# EUROPEAN PATENT APPLICATION

(11) **EP 4 503 904 A1**
(43) Date of publication of application: **05.02.2025**
(21) Application number: 22935529.2
(22) Date of filing: 31.03.2022
(51) Int. Cl.: H10N 60/10, H10N 60/80, H10N 60/01

(54) **QUANTUM DEVICE AND METHOD FOR MANUFACTURING QUANTUM DEVICE**

(71) Applicant: FUJITSU LIMITED, Kawasaki-shi, Kanagawa 211-8588 (JP)
(72) Inventor: SHIMANOUCHI, Takeaki, Kawasaki-shi, Kanagawa 211-8588 (JP)
(74) Representative: Haseltine Lake Kempner LLP
(86) International application number: PCT/JP2022/016879
(87) International publication number: WO 2023/188391

(57) **Abstract**

A quantum device includes: a first substrate; and second substrates placed on the first substrate including: a first base member having a first surface; first pads provided on the first surface; and a wiring line coupling two first pads of the first pads, each of the second substrates including: a second base member having a second surface facing the first surface; a second pad provided on the second surface, and facing the first pad; and a quantum bit coupled to the second pad, the quantum device including an alignment mechanism restraining each of the plurality of second substrates within a region in a plane parallel to the first surface of the first substrate, wherein a quantum bit included in one second substrate of the second substrates and a quantum bit included in another one second substrate of the second substrates are capacitively coupled to each other via the wiring line.

## Description

### FIELD

The present disclosure relates to a quantum device and a method for manufacturing the quantum device.

### BACKGROUND

In quantum computing devices and the like including quantum bits, increasing the number of quantum bits has been considered in preparation for an increase in the amount of calculation.

### SUMMARY

### TECHNICAL PROBLEM

In a conventional quantum device, however, it is difficult to stabilize the capacitance between quantum bits in a case where the number of bits is increased.

An object of the present disclosure is to provide a quantum device capable of stabilizing the capacitance between quantum bits, and a method for manufacturing the quantum device.

### SOLUTION TO PROBLEM

According to an embodiment of the present disclosure, a quantum device is provided, and the quantum device includes: a first substrate; and a plurality of second substrates placed on the first substrate. In the quantum device, the first substrate includes: a first base member that has a first surface; a plurality of first pads provided on the first surface; and a wiring line that couples two first pads of the plurality of first pads, each of the plurality of second substrates includes: a second base member that has a second surface that faces the first surface; a second pad that is provided on the second surface and faces the first pad; and a quantum bit coupled to the second pad, a quantum bit included in one second substrate of the plurality of second substrates and a quantum bit included in another one second substrate of the plurality of second substrates are capacitively coupled to each other via the wiring line. The quantum device includes an alignment mechanism that restrains each of the plurality of second substrates within a predetermined region in a plane parallel to the first surface of the first substrate.

### ADVANTAGEOUS EFFECTS OF INVENTION

According to the present disclosure, capacitance between quantum bits can be stabilized.

### BRIEF DESCRIPTION OF DRAWINGS

FIG. 1 is a top view illustrating a quantum device according to a first embodiment.
FIG. 2 is a cross-sectional view illustrating the quantum device according to the first embodiment.
FIG. 3 is a bottom view illustrating a quantum bit substrate included in the quantum device according to the first embodiment.
FIG. 4 is a schematic diagram illustrating a positional relationship between four quantum bit substrates in the quantum device according to the first embodiment.
FIG. 5 is a cross-sectional view illustrating a coupling relationship between two quantum bit substrates in the quantum device according to the first embodiment.
FIG. 6 is a schematic diagram illustrating a coupling relationship between two quantum bit substrates in the quantum device according to the first embodiment.
FIG. 7 is a partial equivalent circuit diagram of the quantum device according to the first embodiment.
FIG. 8 is a cross-sectional view illustrating a method for manufacturing a quantum bit substrate (part 1).
FIG. 9 is a cross-sectional view illustrating the method for manufacturing a quantum bit substrate (part 2).
FIG. 10 is a cross-sectional view illustrating the method for manufacturing a quantum bit substrate (part 3).
FIG. 11 is a cross-sectional view illustrating the method for manufacturing a quantum bit substrate (part 4).
FIG. 12 is a cross-sectional view illustrating the method for manufacturing a quantum bit substrate (part 5).
FIG. 13 is a cross-sectional view illustrating the method for manufacturing a quantum bit substrate (part 6).
FIG. 14 is a cross-sectional view illustrating the method for manufacturing a quantum bit substrate (part 7).
FIG. 15 is a cross-sectional view illustrating the method for manufacturing a quantum bit substrate (part 8).
FIG. 16 is a cross-sectional view illustrating the method for manufacturing a quantum bit substrate (part 9).
FIG. 17 is a cross-sectional view illustrating the method for manufacturing a quantum bit substrate (part 10).
FIG. 18 is a cross-sectional view illustrating the method for manufacturing a quantum bit substrate (part 11).
FIG. 19 is a cross-sectional view illustrating the method for manufacturing a quantum bit substrate (part 12).
FIG. 20 is a cross-sectional view illustrating the method for manufacturing a quantum bit substrate (part 13).
FIG. 21 is a cross-sectional view illustrating the method for manufacturing a quantum bit substrate (part 14).
FIG. 22 is a cross-sectional view illustrating the method for manufacturing a quantum bit substrate (part 15).
FIG. 23 is a cross-sectional view illustrating the method for manufacturing a quantum bit substrate (part 16).
FIG. 24 is a cross-sectional view illustrating the method for manufacturing a quantum bit substrate (part 17).
FIG. 25 is a cross-sectional view illustrating the method for manufacturing a quantum bit substrate (part 18).
FIG. 26 is a cross-sectional view illustrating the method for manufacturing a quantum bit substrate (part 19).
FIG. 27 is a cross-sectional view illustrating the method for manufacturing a quantum bit substrate (part 20).
FIG. 28 is a cross-sectional view illustrating the method for manufacturing a quantum bit substrate (part 21).
FIG. 29 is a cross-sectional view illustrating a method for manufacturing a carrier substrate (part 1).
FIG. 30 is a cross-sectional view illustrating the method for manufacturing a carrier substrate (part 2).
FIG. 31 is a cross-sectional view illustrating the method for manufacturing a carrier substrate (part 3).
FIG. 32 is a cross-sectional view illustrating the method for manufacturing a carrier substrate (part 4).
FIG. 33 is a cross-sectional view illustrating the method for manufacturing a carrier substrate (part 5).
FIG. 34 is a cross-sectional view illustrating the method for manufacturing a carrier substrate (part 6).
FIG. 35 is a cross-sectional view illustrating the method for manufacturing a carrier substrate (part 7).
FIG. 36 is a cross-sectional view illustrating the method for manufacturing a carrier substrate (part 8).
FIG. 37 is a cross-sectional view illustrating the method for manufacturing a carrier substrate (part 9).
FIG. 38 is a cross-sectional view illustrating the method for manufacturing a carrier substrate (part 10).
FIG. 39 is a schematic diagram illustrating another example of the layout of first spacers.
FIG. 40 is a cross-sectional view illustrating a coupling relationship between two quantum bit substrates in a quantum device according to a second embodiment.

### DESCRIPTION OF EMBODIMENTS

In the description below, embodiments of the present disclosure will be specifically explained with reference to the accompanying drawings. Note that, in the present specification and the drawings, components having substantially the same functional configuration are denoted by the same reference signs, and repetitive explanation will not be made.

### (First Embodiment)

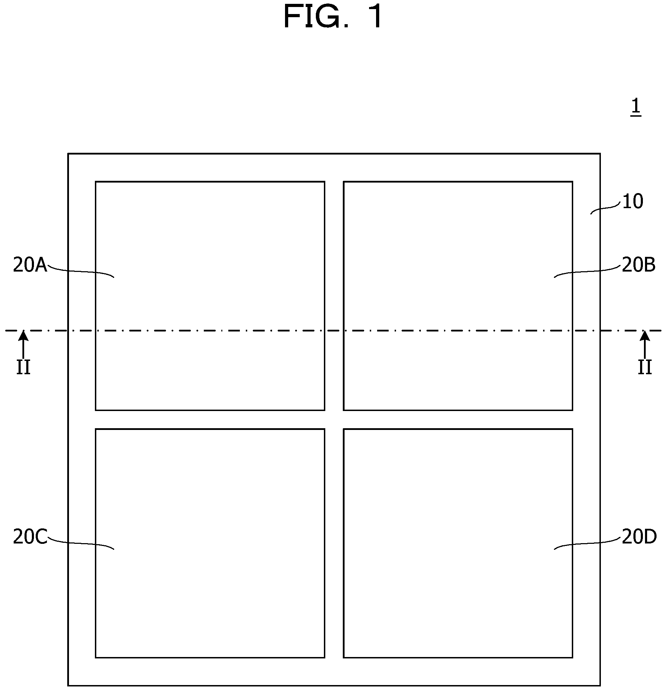

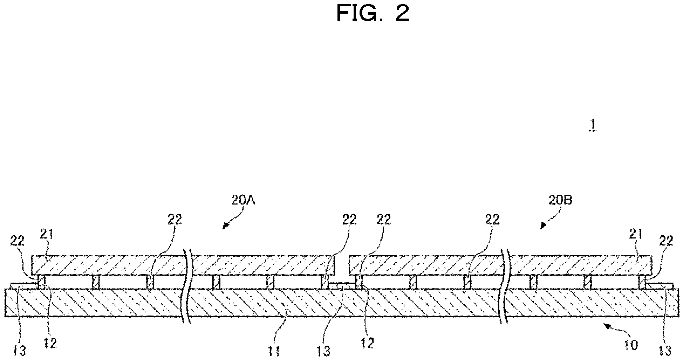

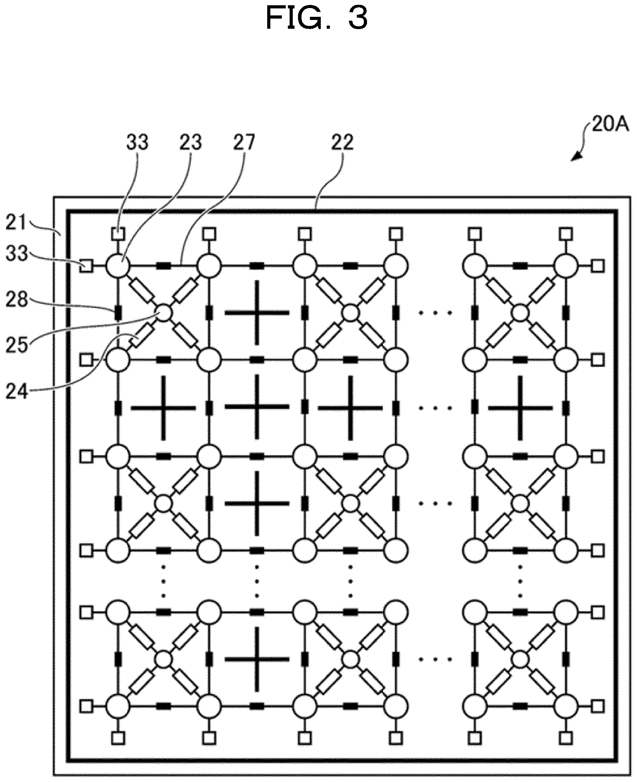

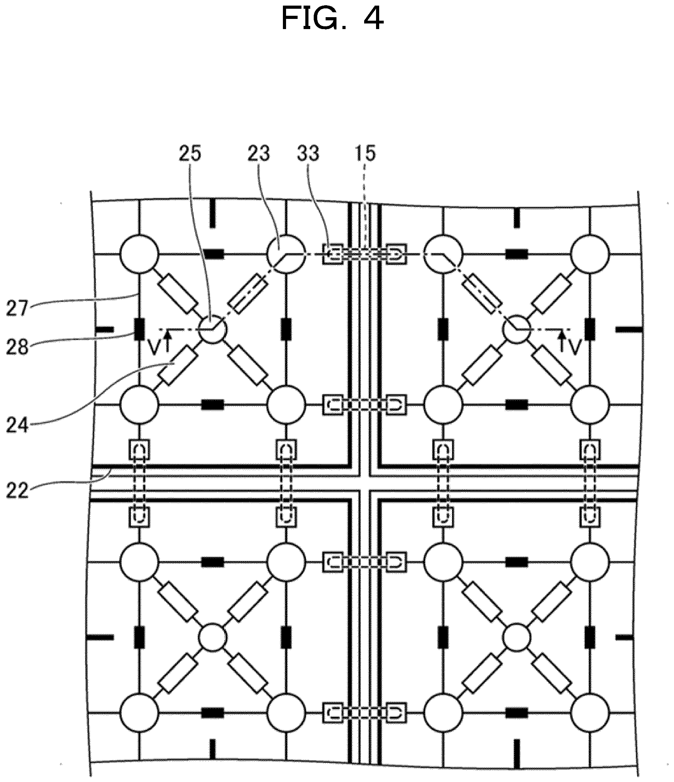

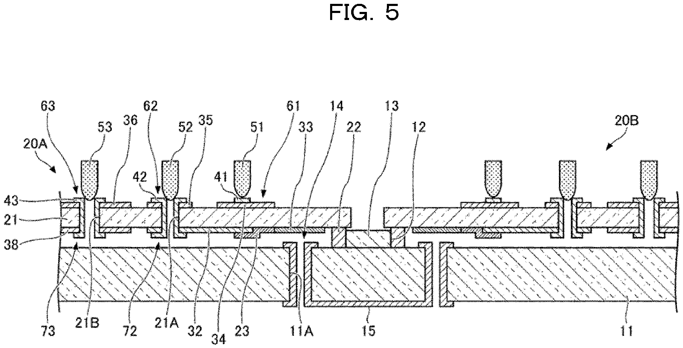

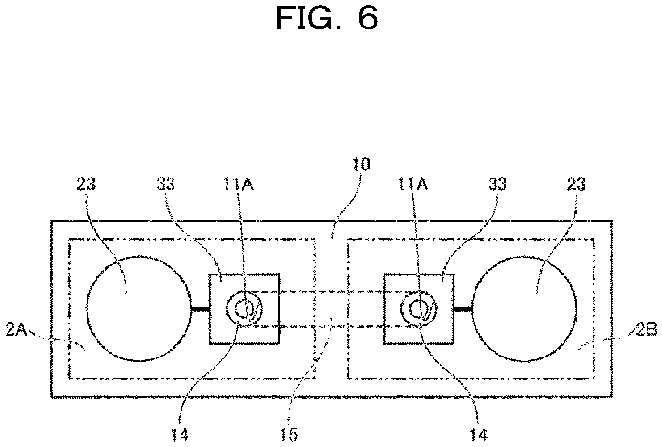

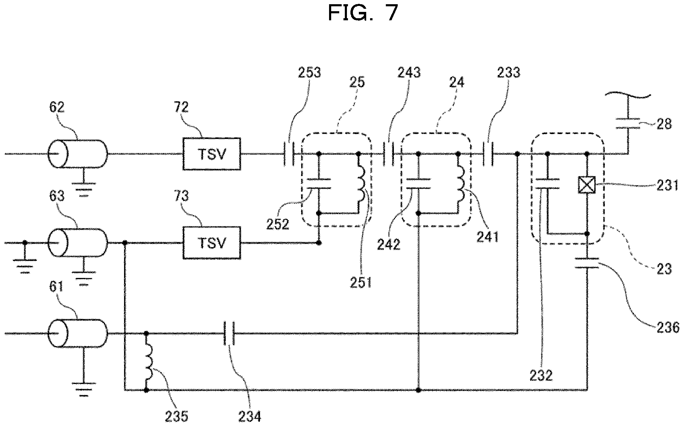

First, a first embodiment is described. The first embodiment relates to a quantum device. FIG. 1 is a top view illustrating the quantum device according to the first embodiment. FIG. 2 is a cross-sectional view illustrating the quantum device according to the first embodiment. FIG. 3 is a bottom view illustrating a quantum bit substrate included in the quantum device according to the first embodiment. FIG. 4 is a schematic diagram illustrating a positional relationship between four quantum bit substrates in the quantum device according to the first embodiment. FIG. 5 is a cross-sectional view illustrating a coupling relationship between two quantum bit substrates in the quantum device according to the first embodiment. FIG. 6 is a schematic diagram illustrating a coupling relationship between two quantum bit substrates in the quantum device according to the first embodiment. FIG. 7 is a partial equivalent circuit diagram of the quantum device according to the first embodiment. FIG. 2 corresponds to a cross-sectional view taken along the line II-II in FIG. 1. FIG. 5 corresponds to a cross-sectional view taken along the line V-V in FIG. 4.

As illustrated in FIG. 1, a quantum device 1 according to the first embodiment includes a carrier substrate 10, a quantum bit substrate 20A, a quantum bit substrate 20B, a quantum bit substrate 20C, and a quantum bit substrate 20D. The carrier substrate 10 is an example of the first substrate, and the quantum bit substrates 20A to 20D are an example of the second substrates. The number of quantum bit substrates is not limited as long as it is two or larger.

As illustrated in FIG. 2, the carrier substrate 10 includes a base member 11, and protruding portions 13 formed on the upper surface of the base member 11. The base member 11 and the protruding portions 13 are formed with silicon, for example. Although the details will be described later, four cavities 12 are formed in a silicon substrate, so that the base member 11 and the protruding portions 13 are formed. The protruding portions 13 are provided at a plurality of locations on the upper surface of the base member 11, and the protruding portions 13 provided at the plurality of locations integrally constitute a frame. The height of the protruding portions 13 is about 2 µm to 4 µm, for example. The upper surface of the base member 11 is an example of the first surface. The protruding portions 13 are part of the alignment mechanism.

The quantum bit substrates 20A to 20D have the same configurations as one another. In the following description of the quantum bit substrates 20A to 20D, only the quantum bit substrate 20A will be explained as a typical example.

The quantum bit substrate 20A includes a base member 21, and a plurality of first spacers 22 provided on the lower surface of the base member 21. As illustrated in FIG. 3, part of the plurality of first spacers 22 is formed in the shape of a rectangular frame, and part of the outer surface of each first spacer 22 is in contact with part of the inner surface of a protruding portion 13 (see FIG. 5). As illustrated in FIG. 3, part of the plurality of first spacers 22 is provided to have a cross shape, for example, inside a first spacer 22 formed in the shape of a rectangular frame. The lower surface of each first spacer 22 is in contact with the upper surface of the base member 11 of the carrier substrate 10. Each first spacer 22 is an Al layer, for example. The height of the first spacers 22 is 4 µm to 6 µm, for example, and is greater than the height of the protruding portions 13. The lower surface of the base member 21 is an example of the second surface. The first spacers 22 are part of the alignment mechanism.

As illustrated specifically in FIGS. 3 to 5, the quantum bit substrate 20A includes quantum bits (qubits) 23, resonators 24, filters 25, pads 33, a control port 61, a read port 62, and a ground port 63.

Each quantum bit 23 is an element that forms a coherent two-level system using superconduction, and has a configuration that includes a transmon quantum bit circuit in which a superconducting Josephson element 231 and a capacitor 232 are coupled in parallel. The superconducting Josephson element 231 includes a pair of superconductors that exhibit superconductivity at a temperature equal to or lower than a predetermined critical temperature, and an ultrathin insulator that has a thickness of about several nanometers and is sandwiched between the pair of superconductors. The superconductor may be aluminum, for example, and the insulator may be aluminum oxide, for example.

A plurality of quantum bits 23 is coupled to adjacent other quantum bits 23 via inter-bit wiring lines 27. Capacitors 28 are provided in the paths of the inter-bit wiring lines 27. With this arrangement, each of the quantum bits 23 creates a quantum entangled state with the adjacent other quantum bits 23, and performs quantum computing. The intervals between the quantum bits 23 are about 2 mm, for example. As illustrated in FIG. 7, a superconducting inductor 236 is coupled between each quantum bit 23 and the ground. FIG. 7 illustrates only the components in the vicinity of one quantum bit 23.

The resonators 24 interact with the quantum bits 23, to read bit signals indicating the states of the quantum bits 23. The resonators 24 are coupled to the quantum bits 23 via capacitors 233. Each resonator 24 includes a resonance circuit in which a superconducting inductor 241 and a capacitor 242 are coupled in parallel.

The filters 25 are coupled to the resonators 24 via capacitors 243. Each filter 25 includes a circuit in which a superconducting inductor 251 and a capacitor 252 are coupled in parallel.

The pads 33 are coupled to some of the quantum bits 23, and are used for coupling to quantum bits 23 provided on the quantum bit substrate 20B or 20C. The pads 33 have a square planar shape, with a side length of about 200 µm, for example. The pads 33 are an example of the second pads. The distance between the pads 33 and the first spacer 22 is about 100 µm to 200 µm, for example. This is to avoid coupling between the pads 33 and the first spacer 22.

For example, four sets of resonators 24 and quantum bits 23 are coupled to each filter 25. The quantum bits 23, the resonators 24, the filters 25, and the pads 33 are provided on the lower surface of the base member 21.

The control port 61, the read port 62, and the ground port 63 are access ports for accessing a quantum computing circuit including the quantum bits 23, the resonators 24, and the filters 25, from the outside. The control port 61, the read port 62, and the ground port 63 are provided on the upper surface of the base member 21.

The control port 61 is coupled to each quantum bit 23 via a capacitor 234. The control port 61 is used to control the quantum bits 23 from the outside. A superconducting inductor 235 is coupled between the ground and the wiring line between the control port 61 and the capacitor 234.

The read port 62 is coupled to each filter 25 via a through silicon via (TSV) 72 provided on the base member 21 and a capacitor 253. The read port 62 is used to extract bit signals read by the resonators 24 to the outside.

The ground port 63 is coupled to the quantum bits 23, the resonators 24, and the filters 25 via the TSV 73. The ground port 63 is used to apply a ground potential to the quantum bits 23, the resonator 24, and the filters 25, from the outside.

As illustrated in FIG. 5, through holes 21A and 21B are formed in the base member 21.

The pads 33, the quantum bits 23, a superconductor layer 32, and a superconductor layer 38 are provided on the lower surface of the base member 21. The pads 33 and the quantum bits 23 are coupled to each other. The superconductor layer 32 forms the resonators 24 and the filters 25, and is coupled to the quantum bits 23. The superconductor layer 32 is adjacent to the through hole 21A. The superconductor layer 38 is adjacent to the through hole 21B. The pads 33, the superconductor layer 32, and the superconductor layer 38 are TiN layers, for example. The thicknesses of the pads 33, the superconductor layer 32, and the superconductor layer 38 are about 100 nm, for example.

A superconductor layer 34, a superconductor layer 35, and a superconductor layer 36 are provided on the upper surface of the base member 21. The superconductor layer 34 overlaps the quantum bits 23 in a planar view. The superconductor layer 35 is adjacent to the through hole 21A, and is included in the TSV 72. The superconductor layer 36 is adjacent to the through hole 21B, and is included in the TSV 73. The superconductor layer 34, the superconductor layer 35, and the superconductor layer 36 are TiN layers, for example. The thicknesses of the superconductor layer 34, the superconductor layer 35, and the superconductor layer 36 are about 100 nm, for example.

A superconductor layer 41 is provided on the superconductor layer 34, a superconductor layer 42 is provided inside the through hole 21A, and a superconductor layer 43 is provided inside the through hole 21B. The superconductor layer 42 is in contact with the superconductor layers 32 and 35. The superconductor layer 43 is in contact with the superconductor layers 36 and 38. The superconductor layer 42 forms the TSV 72, and the superconductor layer 43 forms the TSV 73. The superconductor layers 41, 42, and 43 are Al layers, for example. The thicknesses of the superconductor layers 41, 42, and 43 is about 300 nm, for example. The superconductor layer 41 is included in the control port 61, the superconductor layer 42 is included in the read port 62, and the superconductor layer 43 is included in the ground port 63.

As illustrated in FIGS. 5 and 6, through holes 11A are formed in the base member 11 of the carrier substrate 10 so as to correspond to the pads 33. The through holes 11A each have a circular planar shape with a diameter of about 150 µm, for example. Further, a coupler pad 14 is provided on the upper surface of the base member 11 around each through hole 11A. The outer rim of each coupler pad 14 has a circular planar shape with a diameter of about 180 µm, for example. The coupler pads 14 are an example of the first pads. Superconductor layers that continue to the coupler pads 14 are provided inside the through holes 11A. A wiring line 15 is provided on the lower surface of the base member 11. The wiring line 15 continues to the superconductor layers inside two through holes 11A. Accordingly, two coupler pads 14 are coupled to each other via the wiring line 15. The two coupler pads 14 coupled via the wiring line 15 correspond to different quantum bit substrates from each other. In the example illustrated in FIG. 5, one of the coupler pads 14 corresponds to the quantum bit substrate 20A, and the other coupler pad 14 corresponds to the quantum bit substrate 20B.

The coupler pads 14 face the pads 33, with a distance being maintained from the pads 33. A pad 33 and a coupler pad 14 can function as two electrodes included in one capacitance. In a planar view, the pads 33 have a rectangular shape, and the coupler pads 14 have an annular shape. The coupler pads 14 may be circular. In a planar view, the outer rim of each coupler pad 14 is located on the inner side of the outer rim of the pad 33.

A control probe 51, a read probe 52, and a ground probe 53 are pressed against the upper surface of the quantum bit substrate 20A. The control probe 51 is pressed against the control port 61, the read probe 52 is pressed against the read port 62, and the ground probe 53 is pressed against the ground port 63.

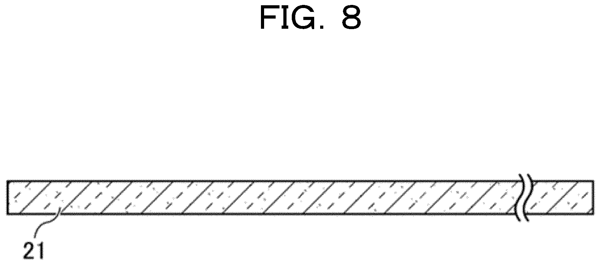

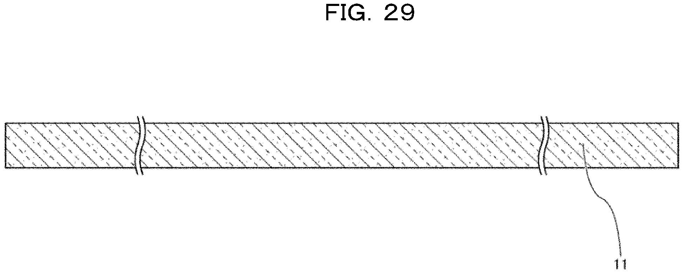

Next, a method for manufacturing the quantum device 1 according to the first embodiment is described. Here, a method for manufacturing the quantum bit substrate 20A, a method for manufacturing the carrier substrate 10, and a method for aligning the quantum bit substrate 20A and the carrier substrate 10 are sequentially described. FIGS. 8 to 28 are cross-sectional views illustrating the method for manufacturing the quantum bit substrate 20A, and FIGS. 29 to 38 are cross-sectional views illustrating the method for manufacturing the carrier substrate 10. In the description of the method for manufacturing the quantum bit substrate 20A, the quantum device 1 is turned upside down, for convenience sake.

In the manufacturing of the quantum bit substrate 20A, the base member 21 is first prepared, as illustrated in FIG. 8. As the base member 21, a silicon substrate can be used, for example. The thickness of the base member 21 is about 300 µm, for example.

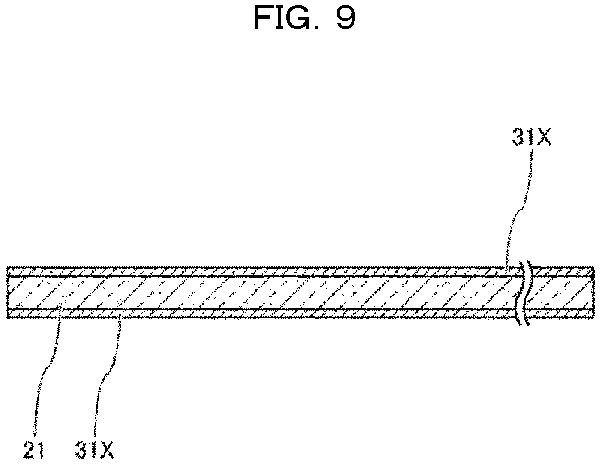

Next, as illustrated in FIG. 9, superconductor layers such as TiN layers 31X, for example, are formed on the upper surface and the lower surface of the base member 21. The TiN layers 31X can be formed by a sputtering method, a plasma chemical vapor deposition (CVD) method, an ion plating method, or the like, for example. The thickness of the TiN layers 31X is about 100 nm, for example.

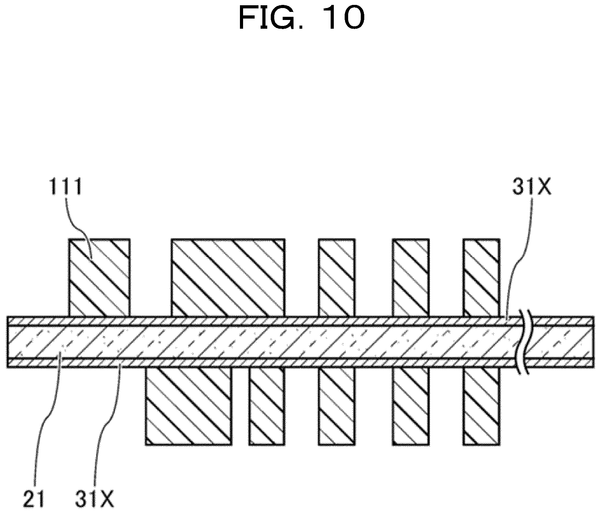

After that, as illustrated in FIG. 10, resist masks 111 are formed on the surfaces of the two TiN layers 31X by a photolithography technique. The resist masks 111 cover the portions of the TiN layers 31X that are to form the pads 33, the superconductor layer 32, the superconductor layer 34, the superconductor layer 35, the superconductor layer 36, or the superconductor layer 38.

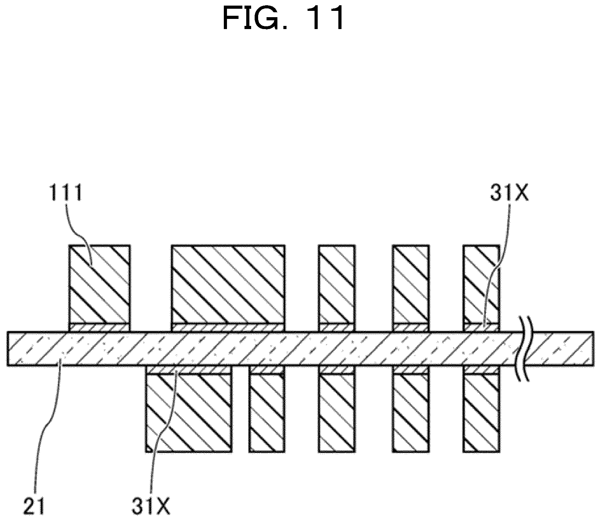

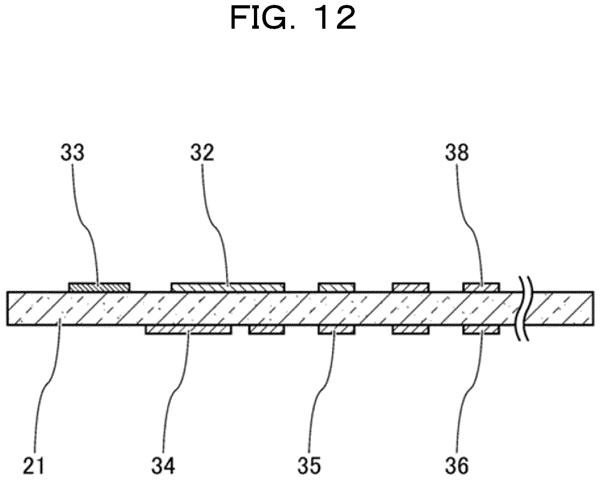

Subsequently, as illustrated in FIG. 11, etching is performed on the TiN layers 31X, using the resist masks 111. Then, the resist masks 111 are then removed, as illustrated in FIG. 12. In this manner, the pads 33, the superconductor layer 32, the superconductor layer 34, the superconductor layer 35, the superconductor layer 36, and the superconductor layer 38 are formed.

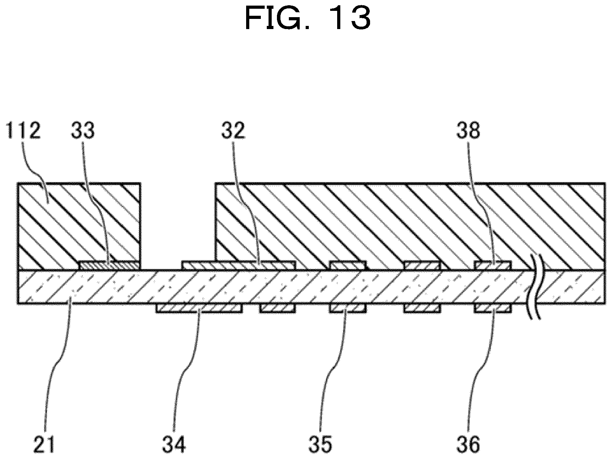

Next, as illustrated in FIG. 13, a resist mask 112 is formed on the upper surface of the base member 21 by a photolithography technique. The resist mask 112 exposes the portions that are to form the quantum bits 23.

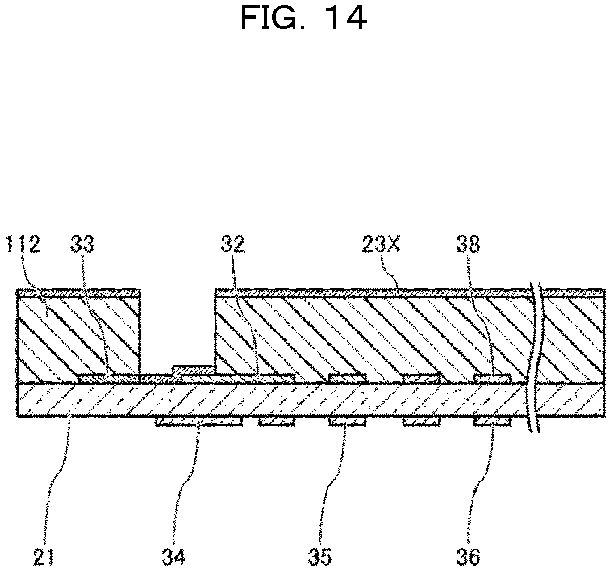

After that, as illustrated in FIG. 14, a film 23X to form the quantum bits 23 is formed. The film 23X may be formed by a vapor deposition method, for example.

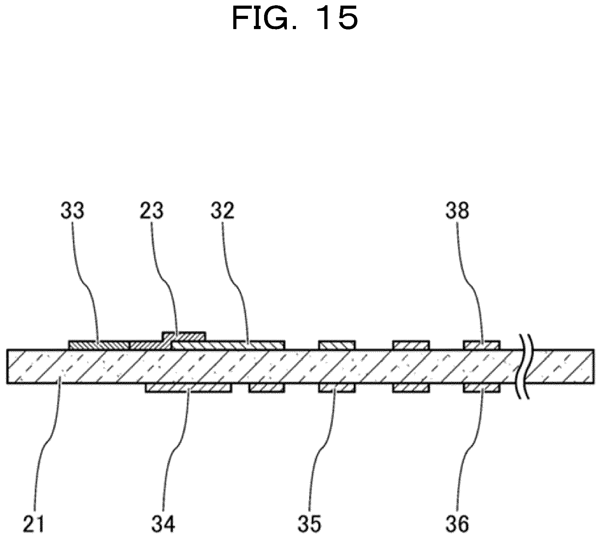

Subsequently, as illustrated in FIG. 15, the resist mask 112 is removed, together with the film 23X formed thereon. That is, lift-off is performed. As a result, the quantum bits 23 are formed.

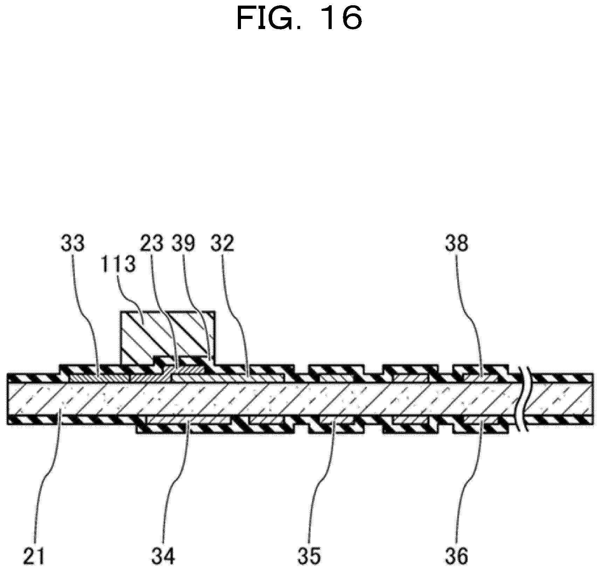

Next, as illustrated in FIG. 16, protective layers 39 are formed on the upper surface and the lower surface of the base member 21. As the protective layers 39, SiO₂ layers are formed, for example. The protective layers 39 can be formed by a CVD method, for example. Further, a resist mask 113 is formed on the protective layer 39 on the upper surface of the base member 21 by a photolithography technique. The resist mask 113 covers the quantum bits 23 from above the protective layer 39.

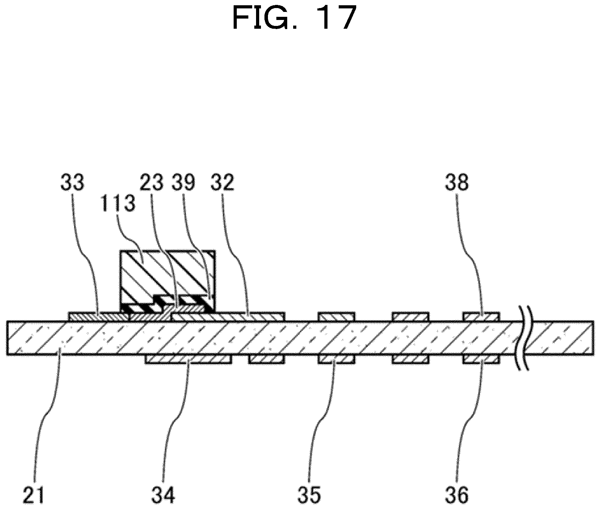

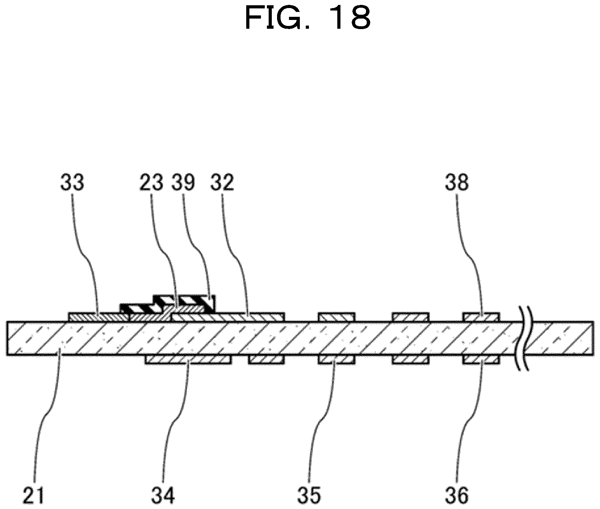

After that, as illustrated in FIG. 17, etching is performed on the protective layer 39, using the resist mask 113. Subsequently, as illustrated in FIG. 18, the resist mask 113 is removed.

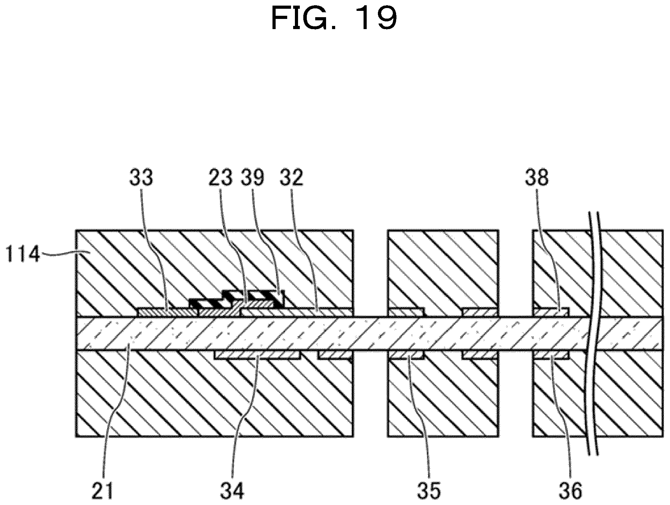

Next, as illustrated in FIG. 19, resist masks 114 are formed on the upper surface and the lower surface of the base member 21 by a photolithography technique. The resist masks 114 expose the portion that is to form the through hole 21A, and the portion that is to form the through hole 21B.

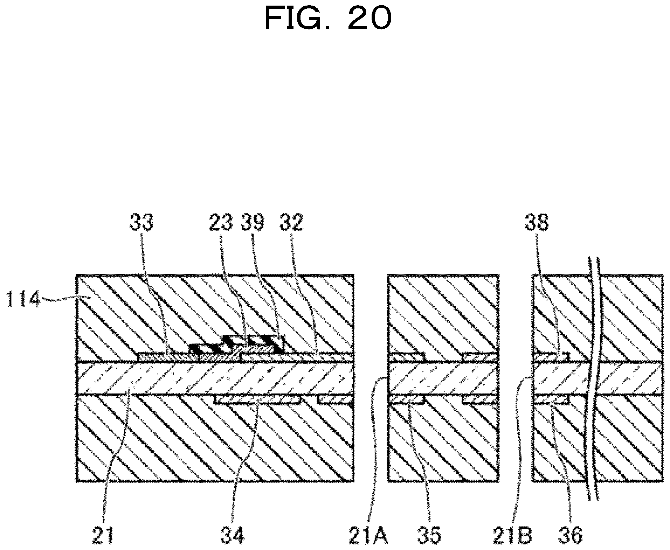

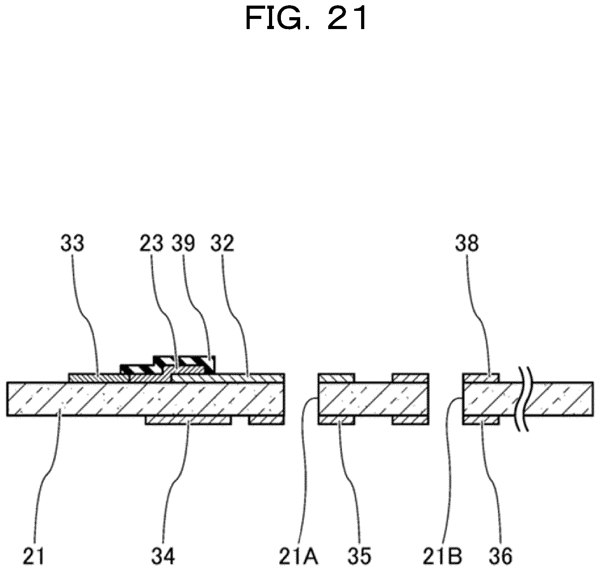

After that, as illustrated in FIG. 20, deep reactive ion etching (Deep-RIE) is performed on the base member 21, using the resist masks 114. As a result, the through holes 21A and 21B are formed in the base member 21. Subsequently, as illustrated in FIG. 21, the resist masks 114 are removed.

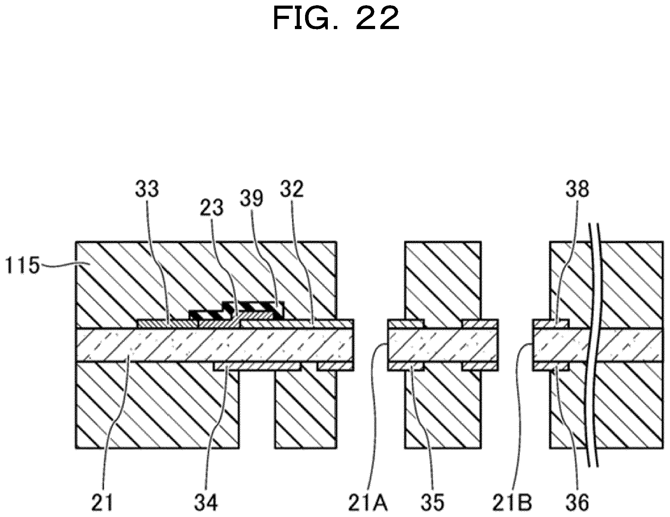

Next, as illustrated in FIG. 22, resist masks 115 are formed on the upper surface and the lower surface of the base member 21 by a photolithography technique. The resist masks 115 expose the portion forming the superconductor layer 41, 42, or 43.

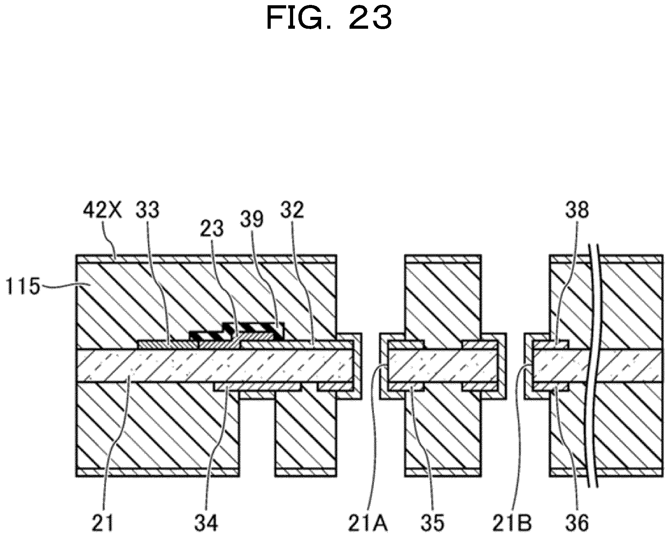

After that, as illustrated in FIG. 23, Al layers 42X are formed as superconductor layers. The Al layers 42X may be formed by a vapor deposition method, for example. The thickness of the Al layers 42X is about 300 nm, for example.

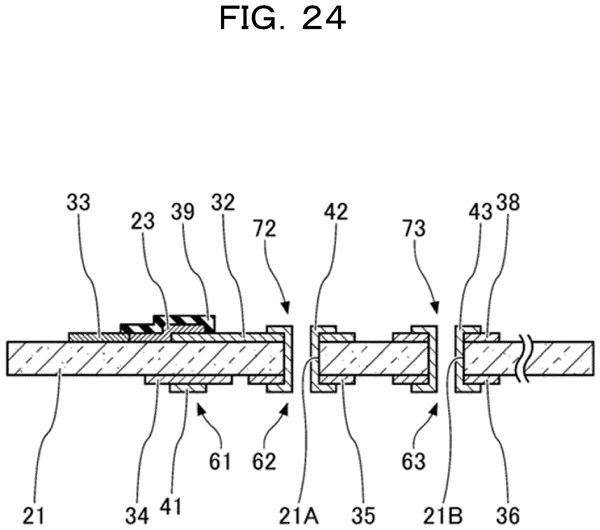

Subsequently, as illustrated in FIG. 24, the resist masks 115 are removed, together with the Al layers 42X formed thereon. That is, lift-off is performed. As a result, the superconductor layers 41, 42, and 43 are formed. The superconductor layer 41 is included in the control port 61, the superconductor layer 42 is included in the read port 62, and the superconductor layer 43 is included in the ground port 63. Further, the superconductor layer 42 forms the TSV 72, and the superconductor layer 43 forms the TSV 73.

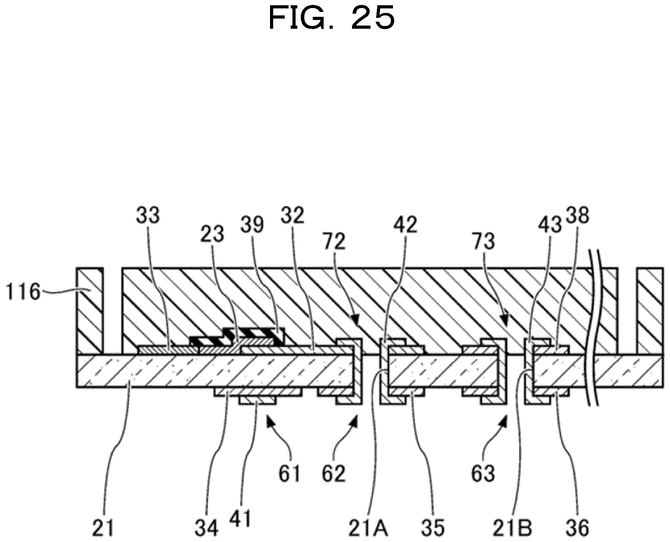

Next, as illustrated in FIG. 25, a resist mask 116 is formed on the upper surface of the base member 21 by a photolithography technique. The resist mask 116 exposes the portions that are to form the first spacers 22.

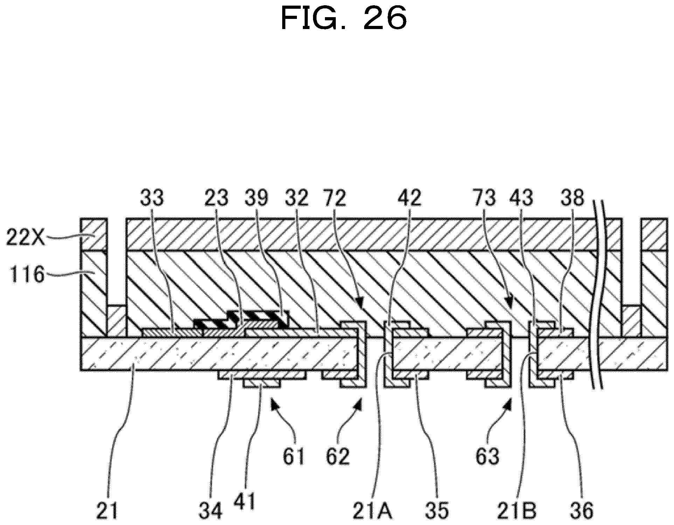

After that, as illustrated in FIG. 26, an Al layer 22X is formed as the film that is to form the first spacers 22. The Al layer 22X may be formed by a vapor deposition method, for example. The thickness of the Al layer 22X is about 4 µm to 6 µm, for example.

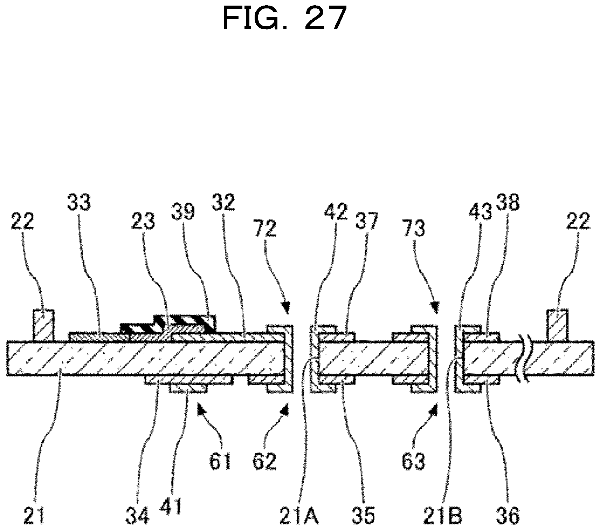

Subsequently, as illustrated in FIG. 27, the resist mask 116 is removed, together with the Al layer 22X formed thereon. That is, lift-off is performed. As a result, the first spacers 22 are formed.

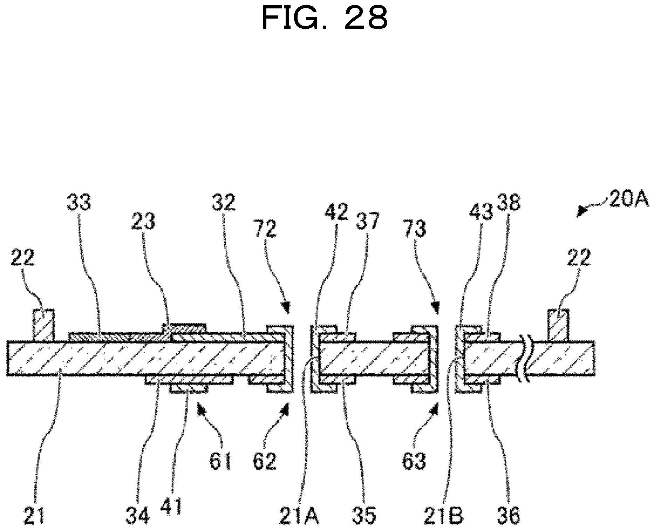

Next, as illustrated in FIG. 28, the protective layers 39 are removed.

In this manner, the quantum bit substrate 20A can be manufactured. The quantum bit substrates 20B, 20C, and 20D can also be manufactured by the same method.

In the manufacturing of the carrier substrate 10, the base member 11 is first prepared, as illustrated in FIG. 29. As the base member 11, a silicon substrate can be used, for example. The thickness of the base member 11 is about 300 µm, for example.

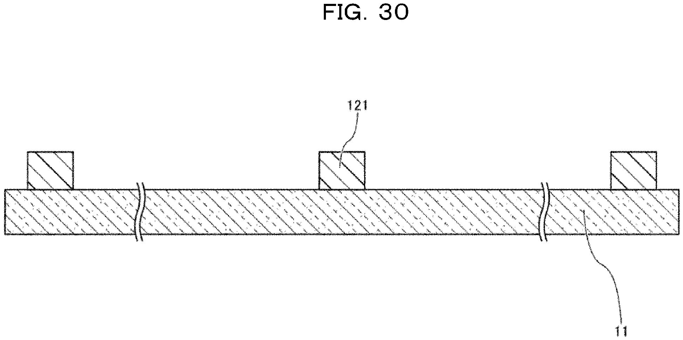

Next, as illustrated in FIG. 30, a resist mask 121 is formed on the upper surface of the base member 11 by a photolithography technique. The resist mask 121 covers the portions that are to form the protruding portions 13.

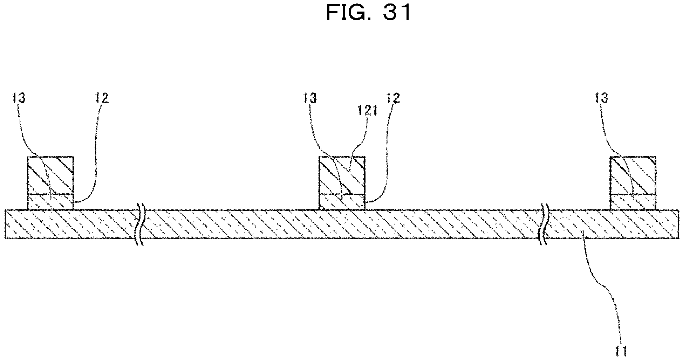

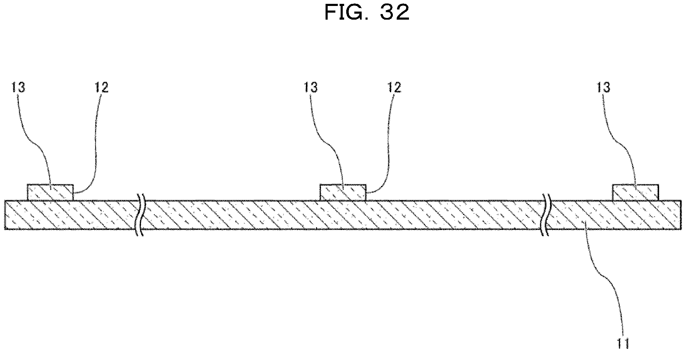

After that, as illustrated in FIG. 31, etching is performed on the base member 11 with the use of the resist mask 121, to form the cavities 12. The depth of the cavities 12 is set to be about 2 µm to 4 µm, for example. As a result, the protruding portions 13 having a height of about 2 µm to 4 µm are formed around the cavities 12. Subsequently, as illustrated in FIG. 32, the resist mask 121 is removed.

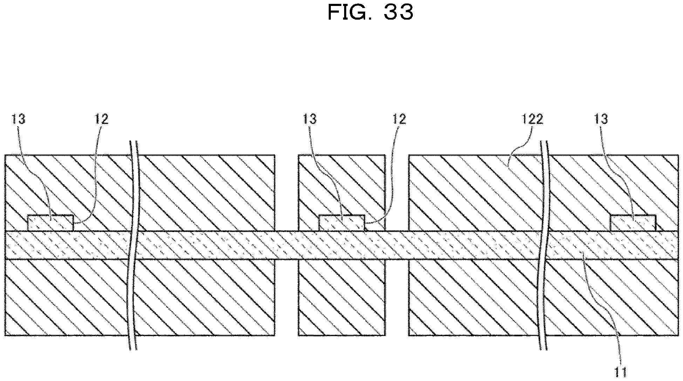

Next, as illustrated in FIG. 33, resist masks 122 are formed on the upper surface and the lower surface of the base member 11 by a photolithography technique. The resist masks 122 expose the portions that are to form the through holes 11A.

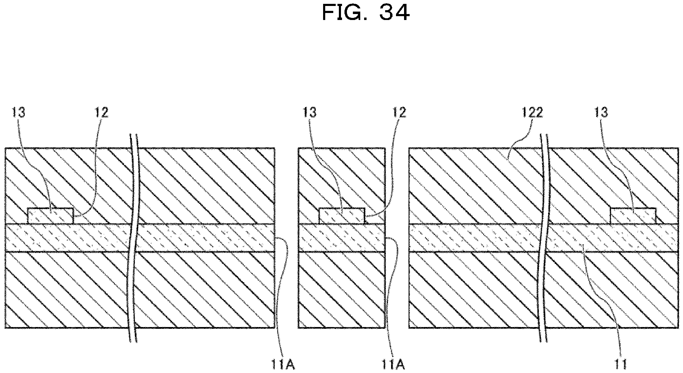

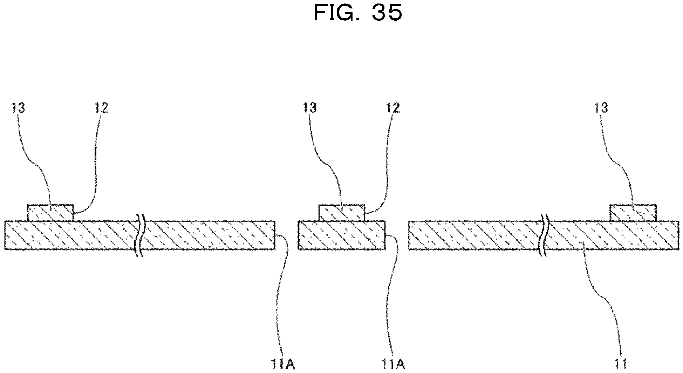

After that, as illustrated in FIG. 34, Deep-RIE is performed on the base member 11, using the resist masks 122. As a result, the through holes 11A are formed in the base member 11. Subsequently, as illustrated in FIG. 35, the resist masks 122 are removed.

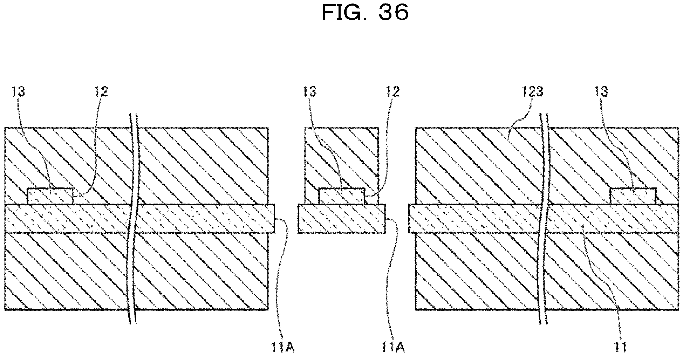

Next, as illustrated in FIG. 36, resist masks 123 are formed on the upper surface and the lower surface of the base member 11 by a photolithography technique. The resist masks 123 expose the portions that are to form the coupler pads 14, the wiring lines 15, and the superconductor layers that join these coupler pads 14 and wiring lines 15.

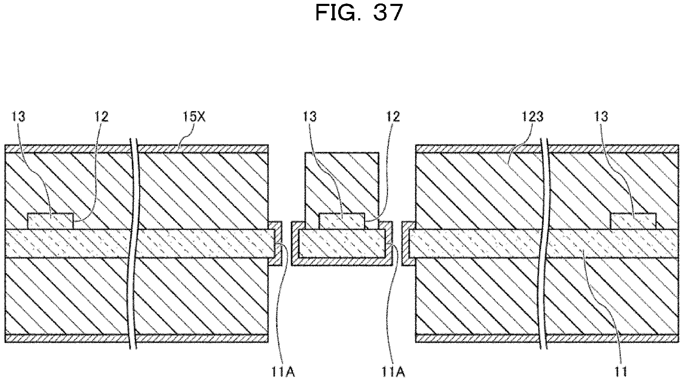

After that, as illustrated in FIG. 37, Al layers 15X are formed as superconductor layers. The Al layers 15X may be formed by a vapor deposition method, for example.

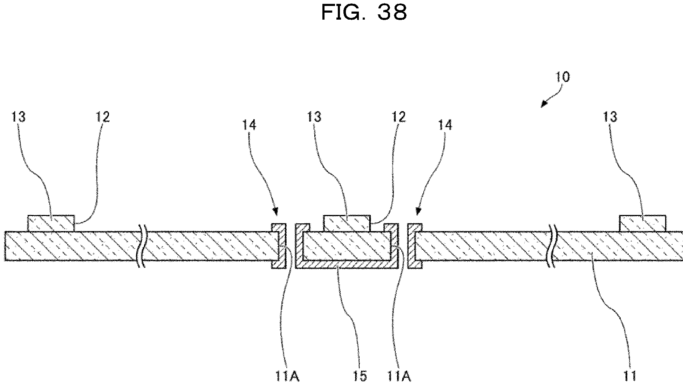

Subsequently, as illustrated in FIG. 38, the resist masks 123 are removed, together with the Al layers 15X formed thereon. That is, lift-off is performed. As a result, the coupler pads 14, the wiring lines 15, and the superconductor layers that join these coupler pads 14 and wiring lines 15 are formed.

In this manner, the carrier substrate 10 can be manufactured.

When the quantum bit substrate 20A and the carrier substrate 10 are aligned, the upper surface of the carrier substrate 10 and the lower surface of the quantum bit substrate 20A are made to face each other. Next, the first spacers 22 are disposed in the cavities 12. That is, the first spacers 22 are disposed in the regions surrounded by the protruding portions 13. Then, the quantum bit substrate 20A is then placed on the carrier substrate 10 while part of the outer surfaces of the first spacers 22 is brought into contact with part of the inner surfaces of the protruding portions 13. As a result, the lower surfaces of the first spacers 22 are in contact with the upper surface of the base member 11. After that, the control probe 51 is pressed against the control port 61, the read probe 52 is pressed against the read port 62, and the ground probe 53 is pressed against the ground port 63.

In this manner, the quantum bit substrate 20A and the carrier substrate 10 can be aligned. The alignment between the carrier substrate 10 and the quantum bit substrates 20B, 20C, and 20D can also be performed by a similar method.

In this manner, the quantum device 1 according to the first embodiment is completed.

In the first embodiment, the first spacers 22 are provided on the lower surface of the base member 21, and thus, a relative positional relationship in the thickness direction between the quantum bit substrate 20A and the carrier substrate 10 is maintained. That is, the distance between the pads 33 and the coupler pads 14 is kept constant. Also, part of the outer surfaces of the first spacers 22 is in contact with part of the inner surfaces of the protruding portions 13. Therefore, the relative position of the quantum bit substrate 20A with respect to the carrier substrate 10 is restricted in a plane parallel to the upper surface of the base member 11. That is, the quantum bit substrate 20A is restricted within a predetermined region that is set beforehand in a plane parallel to the upper surface of the base member 11, by the protruding portions 13 and the first spacers 22. Accordingly, the area in which the pads 33 and the coupler pads 14 overlap each other is kept constant in a planar view. Thus, fluctuations in capacitance between the pads 33 and the coupler pads 14 are reduced. In other words, the capacitance between the pads 33 and the coupler pads 14 is stabilized. Likewise, the capacitance between the pads 33 and the coupler pads 14 is stabilized in the other quantum bit substrates 20B, 20C, and 20D.

In the present embodiment, on the carrier substrate 10, two coupler pads 14 are coupled via a wiring line 15. Accordingly, the quantum bits 23 included in the quantum bit substrate 20A and the quantum bits 23 included in the quantum bit substrate 20B are capacitively coupled to each other via the wiring lines 15. Likewise, the quantum bits 23 included in the quantum bit substrate 20B and the quantum bits 23 included in the quantum bit substrate 20C are capacitively coupled to each other via the wiring lines 15. The quantum bits 23 included in the quantum bit substrate 20C and the quantum bits 23 included in the quantum bit substrate 20D are capacitively coupled to each other via the wiring lines 15. The quantum bits 23 included in the quantum bit substrate 20D and the quantum bits 23 included in the quantum bit substrate 20A are capacitively coupled to each other via the wiring lines 15.

Thus, according to the first embodiment, the capacitance between the quantum bits can be stabilized, and the number of bits can be increased while a stable capacitance is obtained.

Further, the pressing by the control probe 51, the read probe 52, and the ground probe 53 is stopped, so that the quantum bit substrates 20A, 20B, 20C, or 20D can be easily removed from the carrier substrate 10. Thus, even in a case where an operation failure or the like occurs in any of the quantum bit substrates 20A, 20B, 20C, and 20D, the quantum bit substrate can be easily replaced (repaired).

Further, in a case where the first spacers 22 are Al layers, the ground layer of the quantum bit substrate 20A and the ground layer of the carrier substrate 10 can be electrically coupled via the first spacers 22.

Note that the quantum bit substrate 20A may not be completely restrained in a plane parallel to the upper surface of the base member 11 by the contact between the protruding portions 13 and the first spacers 22. For example, there may be a distance between the protruding portions 13 and the first spacers 22 so that the quantum bit substrate 20A can be easily placed on the carrier substrate 10. In this case, in each direction in the plane parallel to the upper surface of the base member 11, the difference between the distance between the outer rims of the pads 33 and the distance between the outer rims of the coupler pads 14 is preferably larger than the amount by which the quantum bit substrate 20A can move. With such a configuration, even if the quantum bit substrate 20A moves in the plane, the area where the pads 33 and the coupler pads 14 overlap each other in a planar view is kept constant, and a stable capacitance can be obtained.

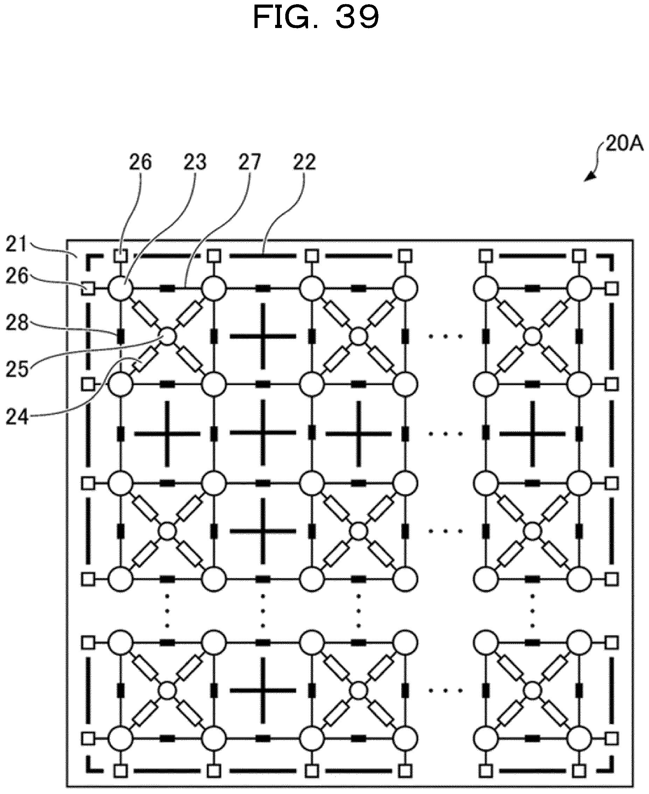

Further, in the quantum bit substrate 20A included in the first embodiment, some of the first spacers 22 are located between the pads 33 and the outer rim of the base member 21 in a planar view (see FIG. 3). However, as illustrated in FIG. 39, the first spacers 22 may not be located between the pads 33 and the outer rims of the base member 21.

Furthermore, the material of the first spacers 22 is not limited to Al, but may be Cu, Au, or the like.

### (Second Embodiment)

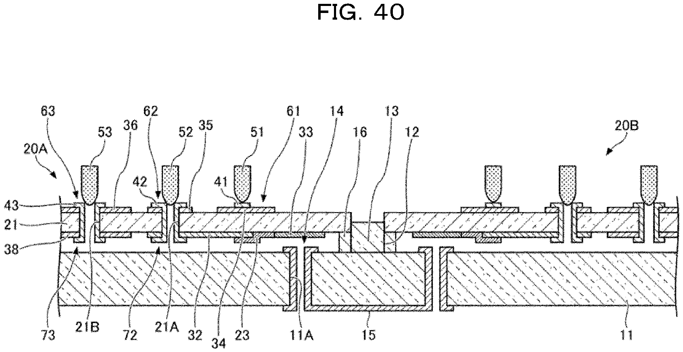

Next, a second embodiment is described. The second embodiment differs from the first embodiment mainly in the configuration of the alignment mechanism. FIG. 40 is a cross-sectional view illustrating a coupling relationship between two quantum bit substrates in a quantum device according to the second embodiment.

In the second embodiment, the protruding portions 13 are formed to be higher than the first spacers 22 of the first embodiment. Further, the carrier substrate 10 has second spacers 16 at a plurality of locations inside the cavities 12. That is, the second spacers 16 are provided on the upper surface of the base member 11. The height of the second spacers 16 is about the same as the height of the first spacers 22 of the first embodiment, and is 4 µm to 6 µm, for example. The second spacers 16 continue to the protruding portions 13, for example. The second spacers 16 are formed with silicon, for example, and are formed integrally with the base member 11 and the protruding portions 13. The second spacers 16 are part of the alignment mechanism.

Further, in the present embodiment, the quantum bit substrate 20A does not have the first spacers 22, and part of the outer surface of the base member 21 of the quantum bit substrate 20A is in contact with part of the inner surfaces of the protruding portions 13. The upper surfaces of the second spacers 16 are in contact with the lower surface of the base member 21 of the quantum bit substrate 20A.

Other components are the same as those of the first embodiment.

In the second embodiment, when the quantum bit substrate 20A and the carrier substrate 10 are aligned, the upper surface of the carrier substrate 10 and the lower surface of the quantum bit substrate 20A are made to face each other. The quantum bit substrate 20A is then placed on the carrier substrate 10 while part of the outer surface of the base member 21 is brought into contact with part of the inner surfaces of the protruding portions 13. As a result, the upper surfaces of the second spacers 16 are in contact with the lower surface of the base member 21. After that, the control probe 51 is pressed against the control port 61, the read probe 52 is pressed against the read port 62, and the ground probe 53 is pressed against the ground port 63.

In the second embodiment, the second spacers 16 are provided on the upper surface of the base member 11, and thus, a relative positional relationship in the thickness direction between the quantum bit substrate 20A and the carrier substrate 10 is maintained. That is, the distance between the pads 33 and the coupler pads 14 is kept constant. Also, part of the outer surface of the base member 21 is in contact with part of the inner surfaces of the protruding portions 13. Therefore, the relative position of the quantum bit substrate 20A with respect to the carrier substrate 10 is restricted in a plane parallel to the upper surface of the base member 11. Accordingly, the area in which the pads 33 and the coupler pads 14 overlap each other is kept constant in a planar view. Thus, fluctuations in capacitance between the pads 33 and the coupler pads 14 are reduced. In other words, the capacitance between the pads 33 and the coupler pads 14 is stabilized. Likewise, the capacitance between the pads 33 and the coupler pads 14 is stabilized in the other quantum bit substrates 20B, 20C, and 20D.

Thus, according to the second embodiment, the capacitance between the quantum bits can also be stabilized, and the number of bits can also be increased while a stable capacitance is obtained.

Also, as in the first embodiment, the quantum bit substrate 20A, 20B, 20C, or 20D can be easily removed from the carrier substrate 10, and the quantum bit substrate 20A, 20B, 20C, or 20D can be easily replaced (repaired).

Further, in the second embodiment, the first spacers 22 are unnecessary. Thus, contamination and damage due to the formation of the first spacers 22 can be reduced, and more preferable characteristics can be obtained.

Note that the quantum bit substrate 20A may not be completely restrained in a plane parallel to the upper surface of the base member 11 by the contact between the protruding portions 13 and the base member 21. For example, there may be a distance between the protruding portions 13 and the base member 21 so that the quantum bit substrate 20A can be easily placed on the carrier substrate 10. In this case, in each direction in the plane parallel to the upper surface of the base member 11, the difference between the distance between the outer rims of the pads 33 and the distance between the outer rims of the coupler pads 14 is preferably larger than the amount by which the quantum bit substrate 20A can move. With such a configuration, even if the quantum bit substrate 20A moves in the plane, the area where the pads 33 and the coupler pads 14 overlap each other in a planar view is kept constant, and a stable capacitance can be obtained.

Although the preferred embodiments and the like have been described in detail so far, the present disclosure is not limited to the embodiments and the like described above, and various modifications and substitutions may be made to the embodiments and the like described above, without departing from the scope disclosed in the claims.

### CITATION LIST

### PATENT DOCUMENTS

Patent Document 1: U.S. Patent Application Publication No. 2018/0013052
Patent Document 2: U.S. Patent Application Publication No. 2019/0042964
Patent Document 3: Japanese Laid-open Patent Publication No. 2021-72351
Patent Document 4: Japanese Laid-open Patent Publication No. 2020-61554

### REFERENCE SIGNS LIST

1Quantum device
10Carrier substrate
11Base member
12Cavity
13Protruding portion
14Coupler pad
15Wiring line
16Second spacer
20A, 20B, 20C, 20DQuantum bit substrate
21Base member
21A, 21BThrough hole
22First spacer
23Quantum bit
24Resonator
25Filter
33Pad
51Control probe
52Read probe
53Ground probe
61Control port
62Read port
63Ground port

## Claims

1. A quantum device comprising:
a first substrate; and
a plurality of second substrates placed on the first substrate, wherein
the first substrate includes:
a first base member that has a first surface;
a plurality of first pads provided on the first surface; and
a wiring line that couples two first pads of the plurality of first pads,
each of the plurality of second substrates includes:
a second base member that has a second surface that faces the first surface;
a second pad that is provided on the second surface, and faces the first pad; and
a quantum bit coupled to the second pad,
a quantum bit included in one second substrate of the plurality of second substrates and a quantum bit included in another one second substrate of the plurality of second substrates are capacitively coupled to each other via the wiring line, and
the quantum device comprises an alignment mechanism that restrains each of the plurality of second substrates within a predetermined region in a plane parallel to the first surface of the first substrate.

2. The quantum device according to claim 1, wherein
the alignment mechanism includes protruding portions provided at a plurality of locations on the first surface, and
the protruding portions restrain each of the plurality of second substrates within the predetermined region.

3. The quantum device according to claim 1 or 2, further comprising first spacers that are provided at a plurality of locations on the second surface, and are in contact with the first surface.

4. The quantum device according to claim 1, wherein
the alignment mechanism includes:
protruding portions provided at a plurality of locations on the first surface; and
first spacers that are provided at a plurality of locations on the second surface, and are in contact with the first surface and the protruding portions, and
the protruding portions restrain each of the plurality of second substrates within the predetermined region.

5. The quantum device according to claim 1 or 2, further comprising second spacers that are provided at a plurality of locations on the first surface, and are in contact with the second surface.

6. The quantum device according to claim 1, wherein
the alignment mechanism includes:
protruding portions provided at a plurality of locations on the first surface; and
second spacers that are provided at a plurality of locations on the first surface, and are in contact with the second surface, and
the second base member is in contact with the protruding portions.

7. The quantum device according to claim 6, wherein the second spacers continue to the protruding portions.

8. The quantum device according to any one of claims 1 to 7, wherein, in each direction in the plane parallel to the first surface,
a difference between a distance between outer rims of the second pads and a distance between outer edges of the first pads is larger than a movable amount of each of the plurality of second substrates.

9. The quantum device according to any one of claims 1 to 8, wherein the wiring line is provided on an opposite surface of the first base member from the first surface.

10. A method for manufacturing a quantum device, the method comprising:
a process of preparing a first substrate that includes a first base member that has a first surface, a plurality of first pads provided on the first surface, and a wiring line that couples two first pads of the plurality of first pads;
a process of preparing a plurality of second substrates that include a second base member that has a second surface, a second pad that is provided on the second surface and faces the first pads, and a quantum bit coupled to the second pad; and
a process of placing each of the plurality of second substrates on the first substrate, while causing the second surface to face the first surface, wherein
a quantum bit included in one second substrate of the plurality of second substrates and a quantum bit included in another one second substrate of the plurality of second substrates are capacitively coupled to each other via the wiring line, and
an alignment mechanism restrains each of the plurality of second substrates within a predetermined region in a plane parallel to the first surface of the first substrate.
